# EUROPÄISCHE PATENTANMELDUNG

(11) **EP 0 881 119 A2**
(43) Veröffentlichungstag der Anmeldung: **02.12.1998**
(21) Anmeldenummer: 98109490.7
(22) Anmeldetag: 26.05.1998
(51) Int. Cl.: B60Q 1/076

(54) **Verstellvorrichtung für einen Reflektor eines Fahrzeugscheinwerfers**

(30) Priorität: 31.05.1997 DE 19722964
(71) Anmelder: Hella KG Hueck & Co., 59552 Lippstadt (DE)
(72) Erfinder: Stumpe, Gerhard, 59558 Lippstadt (DE)

(57) **Zusammenfassung**

Verstellvorrichtung für einen Reflektor eines Fahrzeugscheinwerfers mit einem Gehäuse (1), das aus einem topfförmigen Basisteil (2),
- in dem ein axial verschiebbares und mit dem Reflektor koppelbares Verstellelement gelagert ist,
- in dem ein Antriebselement (10) zur Verstellung des Verstellelements und
- in dem eine mit elektrischen Bauelementen bestückte Leiterplatte (11) angeordnet ist,
   und das aus einem Deckel (3) mit einem Steckeranschluß (18) besteht,
   daß Verbindungselemente vorgesehen sind zur elektrischen Kontaktierung von Bauteilen mit einer Leiterbahn der Leiterplatte (11), wobei als Verbindungselement eine Kontaktfeder (21,22) ausgebildet ist, die mit dem zu kontaktierenden Bauteil (10,18) verbunden ist und auf eine vorgegebene Kontaktfläche (14,17) der Leiterplatte (11) drückt.

## Beschreibung

Die Erfindung betrifft eine Verstellvorrichtung für einen Reflektor eines Fahrzeugscheinwerfers mit einem Gehäuse, das aus einem topfförmigen Bauteil, in dem ein axial verschiebbares und mit dem Reflektor koppelbares Verstellelement gelagert ist, in dem ein Antriebselement zur Verstellung des Verstellelements und in dem eine mit elektrischen Bauelementen bestückte Leiterplatte angeordnet ist, und das aus einem Deckel mit einem Steckeranschluß besteht, und daß Verbindungselemente vorgesehen sind zur elektrischen Kontaktierung von Bauteilen mit einer Leiterbahn der Leiterplatte.

Aus der DE 44 20 779 C1 ist eine Verstellvorrichtung für einen Reflektor eines Fahrzeugscheinwerfers bekannt, die zur Kontaktierung von Bauteilen mit einer Leiterbahn der Leiterplatte senkrecht von der Leiterplatte abragende Steckbuchsen einerseits und an dem zu kontaktierenden Bauteil angelenkte Steckerstifte andererseits als Verbindungselemente vorsieht. Nach Einführen der Steckerstifte in die jeweilige Steckbuchse wird der elektrische Kontakt durch klemmende Halterung der Stifte in der Buchse hergestellt. Nachteilig an der bekannten Verstellvorrichtung ist, daß die elektrische Kontaktierung relativ aufwendig und einen großen Bauraumbedarf der Verstellvorrichtung erfordert.

Aufgabe der vorliegenden Erfindung ist es daher, eine Verstellvorrichtung für einen Reflektor eines Fahrzeugscheinwerfers so zu gestalten, daß eine einfache und platzsparende elektrische Kontaktierung von Bauteilen an einer Leiterplatte gewährleistet ist.

Die Aufgabe wird erfindungsgemäß dadurch gelöst, daß als Verbindungselement eine Kontaktfeder ausgebildet ist, die mit dem zu kontaktierenden Bauteil verbunden ist und auf eine vorgegebene Kontaktfläche der Leiterplatte drückt.

Der Vorteil der Erfindung besteht insbesondere darin, daß lediglich ein einziges Verbindungselement zur elektrischen Kontaktierung vorgesehen ist, das mit dem zu kontaktierenden Bauteil verbunden ist. Dadurch, daß das Verbindungselement als Kontaktfeder ausgebildet ist, erfolgt eine elektrische Verbindung, ohne daß an der Leiterplatte ein weiteres Verbindungselement angebracht werden müßte. An der Leiterplatte ist lediglich eine Kontaktfläche aufgebracht, auf die die Kontaktfeder im zusammengebauten Zustand der Verstellvorrichtung drückt und somit den elektrischen Kontakt herstellt. Zusätzlich hat die Kontaktfeder eine Haltefunktion für die Leiterplatte, wobei sie als Abstandhalter zwischen dem Deckel und der Leiterplatte wirkt. In einem Bereich der Leiterplatte, in der die mit den Kontaktfedern korrespondierenden Kontaktflächen angeordnet sind, kann somit auf zusätzliche Maßnahmen zur Lagesicherung der Leiterplatte verzichtet werden.

Nach einer bevorzugten Ausführungsform der Erfindung weist die Kontaktfeder zwei in Querrichtung federnd bewegbare Schenkel mit jeweils einer nach außen weisenden Ausbuchtung auf, wobei die Ausbuchtungen auf einer gemeinsamen Ebene quer zur Kontaktfeder und quer zur Leiterplatte angeordnet sind. Hierdurch werden zwei definierte gegenüberliegende Anlagepunkte zum Deckel einerseits und zur Leiterplatte andererseits gebildet, so daß keine Kippkräfte auf die Leiterplatte wirken können.

Nach einer bevorzugten Ausführungsform der Erfindung weist die Kontaktfeder einen sich diametral erstreckenden Haltearm auf, der in einem Bereich von der Leiterplatte bis zur Innenseite des Deckels oder vice versa verläuft. Hierdurch wird ermöglicht, daß das Anschlußteil des zu kontaktierenden Bauteils in einem Bereich zwischen der Leiterplatte und der Innenseite des Deckels verlaufen kann. Bei auf einer von dem Deckel abgekehrten Seite der Leiterplatte angeordneten Bauteilen kann sich das Anschlußteil desselben neben der Leiterplatte in den Bereich zwischen der Leiterplatte und der Innenseite des Deckels erstrecken, so daß die Bauraumhöhe der Verstellvorrichtung wesentlich verringert werden kann.

Nach einer weiteren Ausgestaltung der Erfindung sind die Kontaktflächen auf der Leiterplatte gabelförmig ausgestaltet, wobei deren Enden jeweils Erhöhungen aufweisen. Hierdurch wird eine sichere elektrische Kontaktierung der Kontaktfeder auf der Kontaktfläche gewährleistet.

Weitere Einzelheiten der Erfindung ergeben sich aus der nachfolgenden ausführlichen Beschreibung und den beigefügten Zeichnungen, in denen eine bevorzugte Ausführungsform der Erfindung beispielsweise veranschaulicht ist.

In den Zeichnungen zeigen:
- Figur 1:: Einen Längsschnitt durch eine Verstellvorrichtung für einen Fahrzeugscheinwerfer,

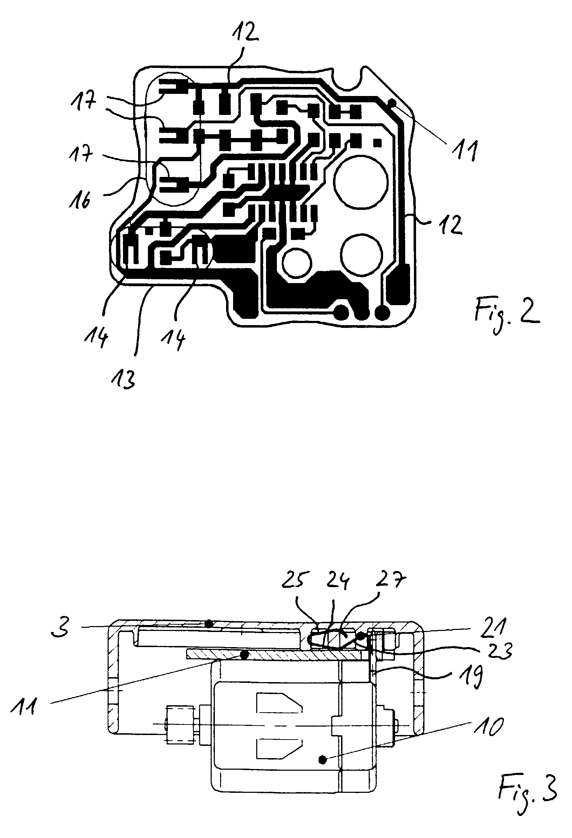

- Figur 2:: eine Draufsicht auf eine in das Gehäuse der Verstellvorrichtung eingesetzten Leiterplatte
- Figur 3:: und einen Längsschnitt durch die Verstellvorrichtung gemäß Richtung X in Figur 1.

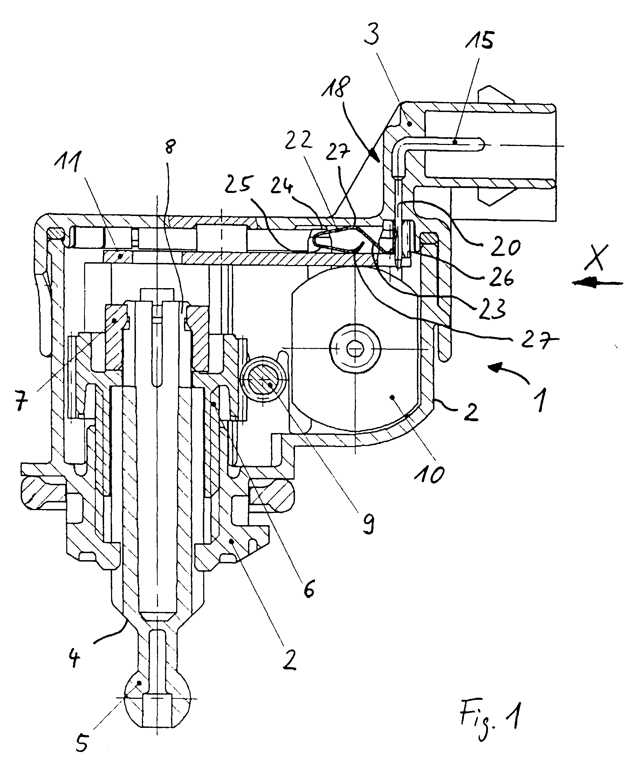

Figur 1 zeigt eine fernbetätigbare elektrische Verstellvorrichtung mit einem Gehäuse (1), das aus einem topfförmigen Basisteil (2) und einem mit diesem lösbar verbindbarem Deckel (3) besteht. In dem topfförmigen Basisteil (2) ist ein Stößel (4) längsverschieblich gelagert, das mittels eines Kugelkopfes (5) gelenkig mit dem nicht dargestellten Reflektor eines Fahrzeugscheinwerfers verbunden ist. Der Reflektor ist somit um eine horizontale Achse schwenkbar ausgebildet. Zur Erzeugung der Längsbewegung des Stößels (4) ist ein Schneckenrad (6) auf das Stößel (4) aufgeschoben und auf diesem mittels eines an dem freien Ende des Stößels (4) aufgeschobenen Befestigungsrings (7) in axialer Richtung gesichert. Zu diesem Zweck weist das Ende des Stößels (4) federnde Arme (8) mit einer Ringnut auf, in die der Befestigungsring (7) selbstrastend eingreift. Das Schneckenrad (6) ist über eine Schnecke (9) mit einer Welle eines elektrischen Motors (10) gekoppelt.

In dem Gehäuse (1) ist eine Leiterplatte (11) gelagert, die eine Mehrzahl von elektrischen Bauelementen aufweist. Die Bauelemente sind mittels auf der Leiterplatte (11) aufgebrachter Leiterbahnen (12) miteinander elektrisch verbunden und stellen eine elektronische Schaltung zur Steuerung des Stößels (4) dar. Die Bauelemente sind an Enden der Leiterbahnen (12) mit denselben durch Lötung elektrisch verbunden. In einem ersten Randbereich (13) der Leiterplatte (11) sind die Enden zweier Leiterbahnen (12) angeordnet, die jeweils eine Kontaktfläche (14) zur elektrischen Verbindung mit einem Anschlußteil (15) des elektrischen Motors (10) aufweist. In einem dazu rechtwinklig angeordneten zweiten Randbereich (16) sind identische Kontaktflächen (17) zur elektrischen Verbindung mit einem in dem Deckel (3) angeordneten Steckeranschluß (18) angeordnet. Die Kontaktflächen (14, 17) sind gabelförmig ausgebildet und weisen an den Enden metallische Erhebungen auf. Zur elektrischen Kontaktierung mit den Kontaktflächen (14, 17) weisen Stifte (19) des Motors (10) bzw. Stifte (20) des Steckeranschlusses (18) auf diese aufgesteckte Kontaktfedern (21) bzw. (22) auf. Die Kontaktfedern (21, 22) bestehen wie die Stifte (19, 20) aus einem metallischen Werkstoff.

Die Kontaktfedern (21, 22) bestehen jeweils aus einem Haltearm (23) und zwei U-förmig ausgebildeten Schenkeln (24, 25), wobei das freie Ende eines Schenkels (24) einstückig mit dem Haltearm (23) verbunden ist. Der Haltearm (23) umfaßt eine Buchse (26), in dessen Öffnung jeweils ein Stift (19, 20) eingreift und durch Klemmung mit diesem verbunden ist. Wie aus Figur 3 zu ersehen ist, sind die Buchsen (26) auf den Stiften (19) des Motors (10) in einem Bereich zwischen der Leiterplatte (11) und der Innenseite des Deckels (3) angeordnet. Von einem deckelnahen Bereich setzt sich der Haltearm (23) von der Buchse (26) diametral in Richtung der Leiterplatte (11) fort und geht in einem leiterplattennahen Schenkel (24) über. Die Schenkel (24, 25) weisen jeweils Ausbuchtungen (27) auf, die auf einer gemeinsamen quer zur Leiterplatte (11) angeordneten Ebene liegen. Die Ausbuchtungen (27) bilden den bevorzugten Anlagepunkt der Kontaktfeder (21) bezüglich der Kontaktflächen (14) einerseits und der Innenseite des Deckels (3) andererseits. Durch die gabelförmige Ausbildung der Kontaktflächen (14) mit den metallischen Erhebungen im Zusammenwirken mit den eine entsprechende Breite aufweisenden Kontaktfedern (21) wird eine definierte Anlagefläche gebildet. Zur Erhöhung der Anlagekraft ist der Abstand zwischen den Ausbuchtungen (27) größer gewählt als der Abstand zwischen der Leiterplatte (11) und der Innenseite des Deckels (3), so daß nach Montage des Deckels (3) auf dem Basisteil (2) eine zusätzliche Anlagekraft wirkt. Die Kontaktfeder (21) ist in Querrichtung zur Leiterplatte (11) federnd ausgebildet, so daß sie zusätzlich einen Abstandhalter zwischen der Leiterplatte (11) und dem Deckel (3) bildet. In dem den Kontaktfedern (21, 22) nahen Bereich der Leiterplatte (11) brauchen daher keine Öffnungen vorgesehen sein, durch die vom topfförmigen Bauteil (2) aus Stege eingreifen, die mit dem Bauteil (2) einstückig verbunden sind und deren Enden an der Innenseite des Deckels (3) anstoßen.

Die Montage der Kontaktfedern (21) erfolgt, nachdem die Leiterplatte (11) in das topfförmige Basisteil (2) eingesetzt worden ist. Die Kontaktfedern (21) werden derart auf die Stifte (19) aufgesteckt, daß der Schenkel (25) mit dem freien Ende zum Deckel (3) hingerichtet sind. Die Kontaktfedern (22) des Steckeranschlusses (18) sind in gleicher Weise ausgebildet und werden auf die Stifte (20) des Steckeranschlusses (18) aufgesetzt. Die Enden des freien Schenkels (25) weisen dabei in Richtung der Leiterplatte (11), so daß nach der Montage des Deckels (3) die Ausbuchtungen (27) der Schenkel (25) auf die korrespondierenden Kontaktflächen (17) klemmend anliegen.

## Patentansprüche

1. Verstellvorrichtung für einen Reflektor eines Fahrzeugscheinwerfers mit einem Gehäuse (1), das aus einem topfförmigen Basisteil (2),
- in dem ein axial verschiebbares und mit dem Reflektor koppelbares Verstellelement gelagert ist,
- in dem ein Antriebselement (10) zur Verstellung des Verstellelements und
- in dem eine mit elektrischen Bauelementen bestückte Leiterplatte (11) angeordnet ist,
und das aus einem Deckel (3) mit einem Steckeranschluß (18) besteht,
daß Verbindungselemente vorgesehen sind zur elektrischen Kontaktierung von Bauteilen mit einer Leiterbahn der Leiterplatte (11), dadurch gekennzeichnet, daß als Verbindungselement eine Kontaktfeder (21, 22) ausgebildet ist, die mit dem zu kontaktierenden Bauteil (10, 18) verbunden ist und auf eine vorgegebene Kontaktfläche (14, 17) der Leiterplatte (11) drückt.

2. Verstellvorrichtung nach Anspruch 1, dadurch gekennzeichnet, daß die Kontaktfeder (21, 22) U-förmig ausgebildet ist mit zwei Schenkein (24, 25), die in Querrichtung federnd bewegbar sind.

3. Verstellvorrichtung nach Anspruch 1 oder 2, dadurch gekennzeichnet, daß die Schenkel (24, 25) jeweils eine nach außen weisende Ausbuchtung (27) aufweisen.

4. Verstellvorrichtung nach Anspruch 3, dadurch gekennzeichnet, daß die Ausbuchtungen (27) gegenüberliegend auf einer gemeinsamen rechtwinklig zur Leiterplatte (11) angeordneten Ebene angeordnet sind, so daß die Ausbuchtung (27) des ersten Schenkels (24) auf der Innenseite des Deckels (3) und die Ausbuchtung des zweiten Schenkels (25) auf der Kontaktfläche der Leiterplatte (11) zur Anlage kommt.

5. Verstellvorrichtung nach einem der Ansprüche 1 bis 4, dadurch gekennzeichnet, daß der Abstand zwischen den Außenseiten der Ausbuchtungen (27) größer ist als der vorgegebene Abstand zwischen der Innenseite des Deckels (3) und der dem Deckel (3) zugekehrten Seite der Leiterplatte (11).

6. Verstellvorrichtung nach einem der Ansprüche 1 bis 5, dadurch gekennzeichnet, daß nur ein einziger Schenkel (24) mittels eines angelenkten Haltearms (23) mit einem Anschlußteil (15) des Bauteils verbunden ist.

7. Verstellvorrichtung nach Anspruch 6, dadurch gekennzeichnet, daß der Haltearm (23) einstückig mit dem Schenkel (24) verbunden ist.

8. Verstellvorrichtung nach Anspruch 6 oder 7, dadurch gekennzeichnet, daß sich der Haltearm (23) im wesentlichen diametral zwischen der Leiterplatte (11) und der Innenseite des Deckels (3) erstreckt, wobei die Enden des Anschlußteils (15) bzw. des Steckeranschlusses (18) in einer solchen Höhe mit dem Haltearm (23) in Verbindung stehen, in der die Ausbuchtung (27) des mit dem freien Ende versehenen Schenkels (25) gebildet ist.

9. Verstellvorrichtung nach einem der Ansprüche 1 bis 8, dadurch gekennzeichnet, daß der Haltearm (23) eine in Querrichtung der Kontaktfeder (21) erstreckende Buchse (26) aufweist, mit der ein Anschlußstift (19, 20) des Anschlußteils (15) oder des Steckeranschlusses (18) klemmend verbunden ist.

10. Verstellvorrichtung nach einem der Ansprüche 1 bis 9, dadurch gekennzeichnet, daß die Kontaktflächen (14, 17) gabelförmig ausgestaltet sind, wobei die Breite der Kontaktflächen (14, 17) etwa der Breite der Kontaktfedern (21, 22) entsprechen und die Enden der Kontaktflächen (14, 17) erhaben ausgebildet sind.
